Europäisches Patentamt

European Patent Office

Office européen des brevets

(19)

(11) Veröffentlichungsnummer: **0 008 374**
**B1**

(12) **EUROPÄISCHE PATENTSCHRIFT**

(45) Veröffentlichungstag der Patentschrift:
02.06.82

(21) Anmeldenummer: 79102602.4

(22) Anmeldetag: 23.07.79

(51) Int. Cl.³: **H 01 L 27/10**, H 01 L 29/78 //
**H03H15/02**

(54) **CCD-Eingangsschaltung nach dem "Fill and Spill"-Prinzip.**

(30) Priorität: 21.08.78 DE 2836473

(43) Veröffentlichungstag der Anmeldung:
05.03.80 Patentblatt 80/5

(45) Bekanntmachung des Hinweises auf die Patenterteilung:
02.06.82 Patentblatt 82/22

(84) Benannte Vertragsstaaten:
FR GB IT

(56) Entgegenhaltungen:
FR-A-2 377 127
US-A-3 969 634
IEEE JOURNAL OF SOLID-STATE CIRCUITS,
Vol. SC-10, April 1975, no. 2; Seiten 81—92, New
York, U.S.A. C. H. SEQUIN et al.: »Linearity of
Electrical Charge Injection into Carge-Coupled
Devices«
IEEE TRANSACTIONS ON ELECTRON DEVICES,
Vol. ED-22, 6. Juni 1975, Seiten 305—309, New
York, U.S.A. M. F. TOMPSETT: »Surface Potential Equilibration Method of Setting Charge in
Charge-Coupled Devices«

(73) Patentinhaber: SIEMENS AKTIENGESELLSCHAFT
Berlin und München, Postfach 22 02 61,
D-8000 München 22 (DE)

(72) Erfinder: Klar, Heiner, Dr., Rossmarkt 8,
D-8000 München 2 (DE)
Erfinder: Mauthe, Manfred, Dipl.-Ing.,
Mauthäuslstrasse 39, D-8000 München (DE)

## CCD-Eingangsschaltung nach dem »Fill and Spill«-Prinzip

Die Erfindung bezieht sich auf eine CCD-Eingangsschaltung nach dem »Fill and Spill«-Prinzip mit einer Eingangsdiode, mehreren Eingangselektroden und mehreren hinter diesen angeordneten Schiebeelektroden.

CCD-Eingänge, die nach dem »Fill and Spill«-Prinzip betrieben werden, dienen auch zugleich als Ladungsverstärker. Indem die Eingangssammelelektrode in ihrer Fläche gegenüber einer CCD-Schiebeelektrode vergrößert wird, kann die flächenspezifische Ladung erhöht werden. Da jedoch die gesamte, aus »fat zero« und Signalanteil bestehende Ladungsmenge von einer CCD-Elektrode aufgenommen werden muß, muß der Arbeitspunkt entsprechend der Verstärkung für den Eingang niedrig eingestellt werden. Es soll nur der Wechselanteil, nicht jedoch der unerwünschte Gleichanteil einer betreffenden Ladung verstärkt werden. Mit zunehmender Verstärkung wandert der Arbeitspunkt des Eingangs in die Anlaufkrümmung, wodurch Verzerrungen entstehen.

Eine Linearisierung des CCD-Eingangs wird bisher durch »Dippen« oder durch Rückkopplung erreicht, vgl. zum Beispiel N. Weste and J. Mavor: »Most amplifiers for performing peripheral integrated circuit functions«, abgedruckt in Electronic Circiuts and Systems, Sept. 1977, Vol. 1, No. 5.

Es sind SCCD (Surface CCD) mit einheitlichen Oxiddicken bekannt, die nach dem »Fill and Spill«-Prinzip betrieben werden, welche eine 2fache flächenspezifische Ladungsverstärkung aufweisen. Da die Signalladung über eine Schwelle fließen muß, stehen für die Eingangselektroden verglichen mit einer CCD-Elektrode nur die halben Hübe im Oberflächenpotential zur Verfügung. Die Flächen der Steuer-Gates und der ersten CCD-Elektroden sind deshalb doppelt so groß wie die nachgeordneten CCD-Elektroden, vgl. zum Beispiel C. H. Séquin and A. M. Mohsen »Linearity of Electrical Injection into Charge-Coupled Devices«, abgedruckt in IEEE Vol. SC-10, April 1975, pp. 81 – 92. Nachteilig ist dabei, daß für den Eingang der optimale Arbeitspunkt bei der halben Vollaussteuerung liegt.

»Aus der US-A-3 969 634 ist eine CCD-Eingangsschaltung mit Eingangsdioden und Schiebeelektroden bekannt, bei der eine Verteilerelektrode sowie eine Barrierenelektrode vorgesehen ist und bei der die Fläche der Verteilerelektrode und die Höhe der durch die Barrierenelektrode erzeugbaren Barriere so bemessen sind, daß ein unerwünschter Gleichanteil der betreffenden Ladung unter der Verteilerelektrode verbleibt und der Wechselanteil oberhalb der Barriere liegt und bei dem seitlich zur Elektrodenreihe zwischen der Verteilerelektrode und der Barrierenelektrode ein Absaug-Gate angeordnet ist«.

Es ist Aufgabe der Erfindung, eine CCD-Eingangsschaltung nach dem »Fill and Spill«-Prinzip zu schaffen, bei der der optimale Arbeitspunkt günstiger als bei den bekannten Schaltungen liegt und ein mitverstärkter unerwünschter Gleichanteil einer betreffenden Ladung unwirksam gemacht wird, so daß eine Verbesserung der Linearität gegenüber herkömmlichen CCD-Eingangsschaltungen gegeben ist. Es soll des weiteren aufgabengemäß ein die Linearität beeinträchtigender Ladungsrückfluß auf einfache Weise verhindert werden. Diese Eigenschaften sollen aufgabengemäß durch eine Struktur erreichbar sein, die kostengünstig gefertigt werden kann.

Die Aufgabe der Erfindung wird durch eine wie eingangs erwähnte CCD-Eingangsschaltung nach dem »Fill and Spill«-Prinzip mit einer Eingangsdiode, mehreren Eingangselektroden und mehreren hinter diesen angeordneten Schiebeelektroden gelöst, die dadurch gekennzeichnet ist, daß jeweils die Fläche einer ersten Schiebeelektrode bzw. einer zweiten Schiebeelektrode gleich der Summe der Flächen einer zweiten Eingangselektrode und einer dritten Eingangselektrode ist, daß zwischen der zweiten Schiebeelektrode und einer vierten Scheibeelektrode eine Verteilelektrode und eine auf einem der halben Taktamplitude entsprechenden festen Potential liegende Barrierenelektrode angeordnet sind, daß die Fläche der Verteilelektrode und die Höhe der durch die Barrierenelektrode erzeugbaren Barriere so zu bemessen sind, daß ein unerwünschter Gleichanteil der betreffenden Ladung unter der Verteilelektrode verbleibt und der Wechselanteil oberhalb der Barriere liegt, daß seitlich zur Elektrodenreihe zwischen der Verteilelektrode und der Barrierenelektrode ein Absaug-Gate und eine Absaugdiode angeordnet sind und daß die nach der Barrierenelektrode folgenden zwei Schiebeelektroden jeweils eine größere Fläche als jeweils alle folgenden Schiebeelektroden haben.

Die Erfindung bietet den Vorteil, daß der Eingang in seinem optimalen Arbeitspunkt bei voller Aussteuerung betrieben werden kann. Indem die Ladung über eine Barriere fließen muß, wird der mitverstärke unerwünschte Gleichanteil vorteilhafterweise subtrahiert. Gleichzeitig wird der mitverstärke Wechselanteil flächenspezifisch verstärkt. So erhöht sich die Differenz zwischen Barriere und einem sich ergebenden neuen Wechselstromarbeitspunkt. Dadurch verbessert sich die Linearität.

Im folgenden wird die Erfindung an Hand mehrerer Figuren erläutert.

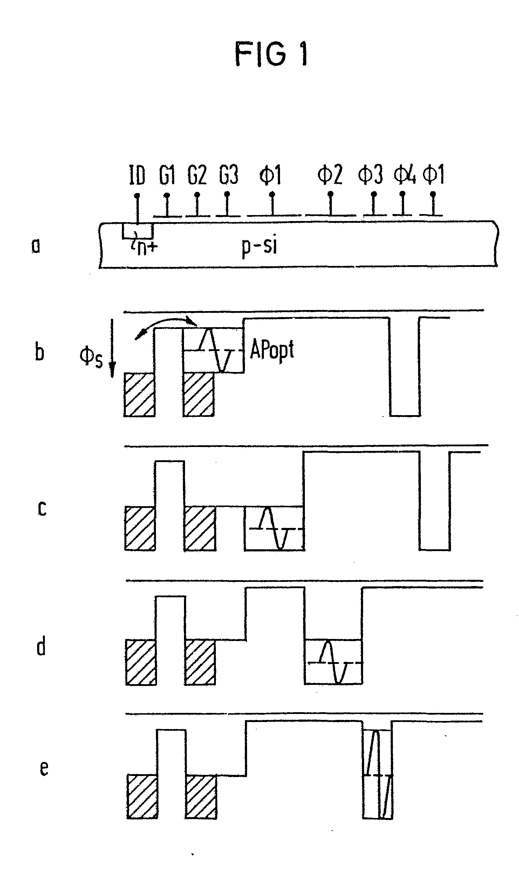

Fig. 1 zeigt eine herkömmliche CCD-Eingangsschaltung mit einer Eingangsdiode ID, einer ersten Eingangselektrode G1, einer zweiten Eingangselektrode G2 und einer dritten Eingangselektrode G3, die nach dem »Fill and Spill«-Prinzip betrieben wird. Ferner enthält sie die vier Schiebeelektroden $\Phi 1$, $\Phi 2$, $\Phi 3$, $\Phi 4$. Ein Eingangssignal $\Phi S$ erfährt eine 2fache flächenspezifische Ladungsverstärkung. Da die Signalladung über die Schwelle von G3 fließen muß, stehen für die Eingangselektroden nur die halben Hübe im Oberflächenpotential verglichen mit einer CCD-Elektrode zur Verfügung. Die Flächen der Eingangselektroden und der ersten CCD-Elektrode sind deshalb doppelt so groß wie die folgenden CCD-Elektroden. Der optimale Arbeitspunkt APopt für die dritte Eingangselektrode G3 liegt, wie eingezeichnet, bei halber Vollaussteuerung.

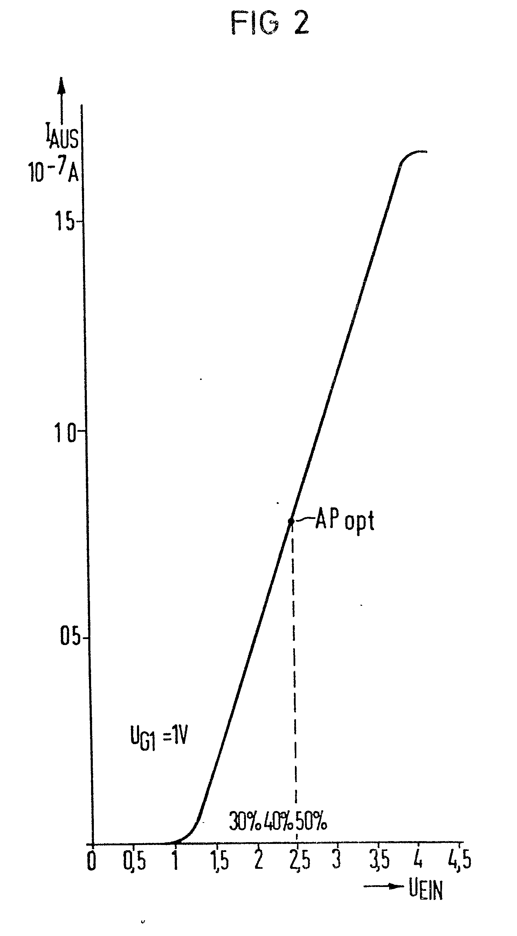

Fig. 2 zeigt die Eingangskennlinie einer gemäß Fig. 1 ausgeführten CCD-Eingangsschaltung.

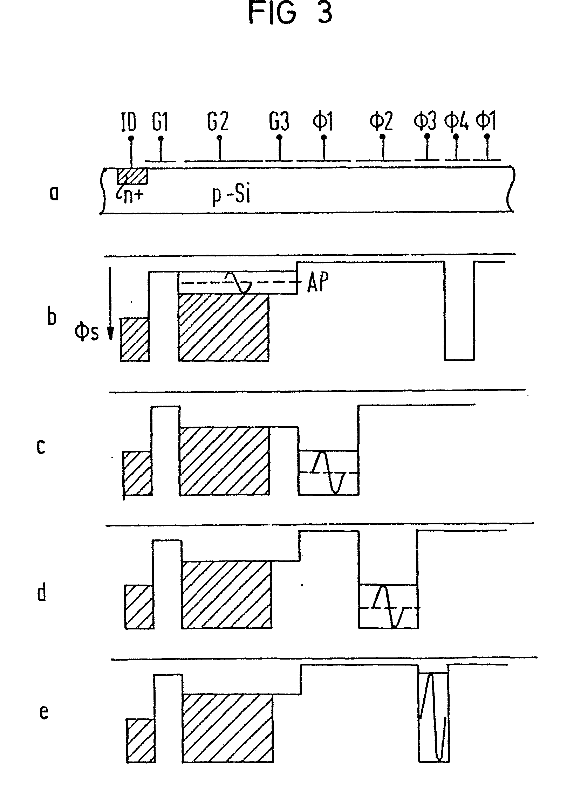

Fig. 3 zeigt eine CCD-Eingangsschaltung herkömmlicher Art, die prinzipiell der in Fig. 1 gezeigten entspricht, jedoch eine vierfache Verstärkung aufweist. Wie ersichtlich, beträgt die Vollaussteuerung der Eingangselektroden G2 und G3 nur noch ein Viertel einer CCD-Elektrode. Der Arbeitspunkt AP geht um den Verstärkungsfaktor zurück. Wie Fig. 2 zeigt, wird der Eingang mit niedriger liegendem Arbeitspunkt zunehmend im nichtlinearen Anlaufgebiet betrieben.

Fig. 4 zeigt die erfindungsgemäße CCD-Eingangsschaltung.

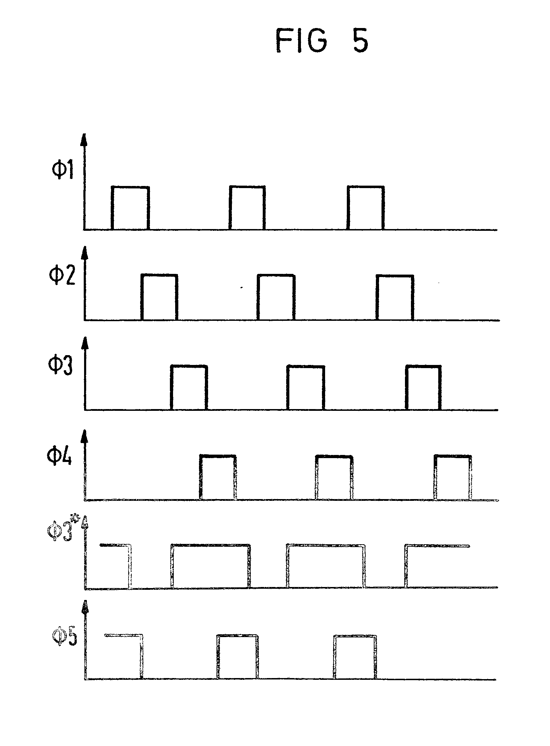

Fig. 5 zeigt den Taktplan zum Betrieb der erfindungsgemäßen CCD-Eingangsschaltung gemäß Fig. 4.

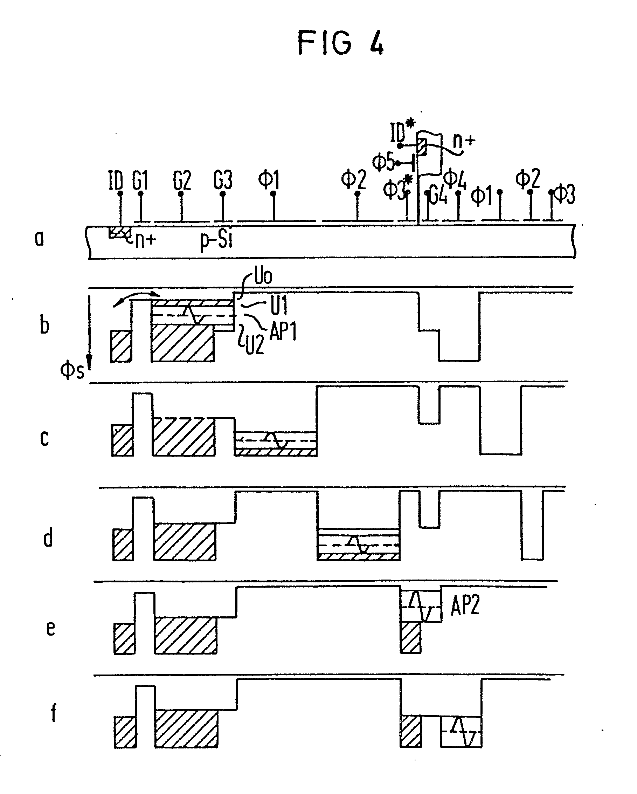

Wie bereits angegeben, zeigt Fig. 4 die erfindungsgemäße CCD-Eingangsschaltung. Die Verstärkung beträgt ebenfalls 4. Der Eingangsarbeitspunkt AP1 ist optimal gewählt. Besonders gekennzeichnet ist der mögliche Aussteuerbereich (U1−U2) und der zu subtrahierende Gleichanteil (U0−U1). Die unter G2 und G3 gespeicherte Ladung fließt mit dem ersten Schiebetakt $\Phi 1$ unter die erste Schiebeelektrode. Um einen Ladungsrückfluß zu verhindern, sind die ersten beiden Schiebeelektroden jeweils flächenmäßig gleich der Summe der Flächen von G2 und G3 ausgelegt. Die Subtraktion des Gleichanteils erfolgt mit der hinter der Verteilelektrode $\Phi 3^*$ angeordneten Barrierenelektrode G4. An G4 liegt eine Gleichspannung, die der halben Taktamplitude entspricht. Mit einem Taktimpuls an der Verteilelektrode $\Phi 3^*$ verteilt sich die Ladung unter den Elektroden $\Phi 3^*$ und G4. Die Fläche von $\Phi 3^*$ und die Höhe der Barriere G4 sind so bemessen, daß der unerwünschte Gleichanteil sich unter $\Phi 3^*$ befindet und der Wechselanteil oberhalb der Barriere liegt. Mit dem Takt $\Phi 4$ fließt nun die Signalladung unter die nächste Elektrode und der Gleichanteil bleibt unter $\Phi 3^*$ zurück. Er wird über ein seitlich angebrachtes Absaug-Gate $\Phi 5$ bzw. eine Absaugdiode ID* mit Hilfe eines Absaugtaktes abgezogen. Da unter $\Phi 3^*$ der gesamte Spannungshub im CCD ausgenutzt wird, tritt eine Verstärkung des Signals ein. Der Wechselstromarbeitspunkt AP2 liegt wie der Eingangsarbeitspunkt AP1 optimal und damit in einem weniger gekrümmten Gebiet der Eingangskennlinie. Für die Gates $\Phi 3^*$, G4 gelten die selben Verhältnisse wie für G2, G3. Die nach der Barrierenelektrode G4 folgenden zwei Elektroden haben die doppelte Fläche wie alle folgenden CCD-Elektroden.

Die vorliegende Erfindung ist nicht auf CCD mit 4-Phasenbetrieb beschränkt. Sie kann vielmehr auch auf 2-Phasen- oder 3-Phasen-CCD bezogen werden.

Mit der gegenüber bei bekannten CCD-Eingangsschaltungen gegebenen verbesserten Linearität der erfindungsgemäßen CCD-Eingangsschaltung lassen sich vorteilhaft Filteranordnungen mit CCD-Resonatoren realisieren, bei denen maximale Verstärkungsfaktoren von 5 bis 10 wünschenswert sind.

## Patentansprüche

1. CCD-Eingangsschaltung nach dem »Fill and Spill«-Prinzip mit einer Eingangsdiode, mehreren Eingangselektroden und mehreren hinter diesen angeordneten Schiebeelektroden, dadurch gekennzeichnet, daß jeweils die Fläche einer ersten Schiebeelektrode ($\Phi 1$) bzw. einer zweiten Schiebeelektrode ($\Phi 2$) gleich der Summe der Flächen einer zweiten Eingangselektrode (G2) und einer dritten Eingangselektrode (G3) ist, daß zwischen der zweiten Schiebeelektrode ($\Phi 2$) und einer vierten Schiebeelektrode ($\Phi 4$) eine Verteilelektrode ($\Phi 3^*$) und eine auf einem der halben Taktamplitude entsprechenden festen Potential liegende Barrierenelektrode (G4) angeordnet sind, daß die Fläche der Verteilelektrode ($\Phi 3^*$) und die Höhe der durch die Barrierenelektrode (G4) erzeugbaren Barriere so zu bemessen sind, daß ein unerwünschter Gleichanteil der betreffenden Ladung unter der Verteilelektrode ($\Phi 3^*$) verbleibt und der Wechselanteil oberhalb der Barriere liegt, daß seitlich zur Elektrodenreihe zwischen der Verteilelektrode ($\Phi 3^*$) und der Barrierenelektrode (G4) ein Absaug-Gate ($\Phi 5$) und eine Absaugdiode (ID*) angeordnet sind und daß die nach der Barrierenelektrode (G4) folgenden zwei Schiebeelektroden ($\Phi 4$ bzw. $\Phi 1$) jeweils eine größere Fläche als jeweils alle folgenden Schiebeelektroden ($\Phi 2$ bzw. $\Phi 3$) haben.

2. CCD-Eingangsschaltung nach Anspruch 1, dadurch gekennzeichnet, daß die nach der Barrierenelektrode (G4) folgenden zwei Schiebeelektroden ($\Phi 4$ bzw. $\Phi 1$) jeweils eine zweifach größere Fläche als jeweils alle folgenden Schiebeelektroden ($\Phi 2$ bzw. $\Phi 3$) haben.

3. Verfahren zum Betrieb einer CCD-Eingangsschaltung nach Anspruch 1 oder 2, dadurch gekennzeichnet, daß jeweils ein zusätzlich zu den an die Schiebeelektroden ($\Phi 1$, $\Phi 2$, $\Phi 3$, $\Phi 4$) zu legenden regulären Schiebetakten vorgesehener Verteiltakt an die Verteilelektrode ($\Phi3^*$) und ein Absaugtakt an das Absaug-Gate ($\Phi5$) zu legen ist, daß die Einschaltflanke des Verteiltaktes zeitlich mit der Einschaltflanke des an die dritte Schiebeelektrode ($\Phi3$) gelegten Schiebetaktes zusammenfällt und die Ausschaltflanke des Verteiltaktes zeitlich nach der Ausschaltflanke des an die vierte Schiebeelektrode ($\Phi4$) gelegten Schiebetaktes liegt und daß die Einschaltflanke des Absaugtaktes zeitlich vor der Ausschaltflanke des an die vierte Schiebeelektrode ($\Phi4$) gelegten Schiebetaktes liegt und die Ausschaltflanke des Absaugtaktes zeitlich nach der Ausschaltflanke des Verteiltaktes liegt.

## Claims

1. A charge-coupled-device (CCD) input circuit operating in accordance with the fill und spill principle, comprising an input diode, a plurality of input elektrodes and a subsequent plurality of shift registers, characterised in that the suface of a first shift electode ($\Phi1$) and of a second shift electrode ($\Phi2$) respectively equals the sum of the surface of a second input electrode (G2) and a third input electrode (G3), and that there are arranged between the second shift electrode ($\Phi2$) an a fourth shift electrode a distribution electrode ($\Phi3^*$) and a barrier electrode (G4) which is connected to a fixed potential corresponding to half the clock pulse amplitude, the surface of the distribution electrode ($\Phi3^*$) and the height of the barrier that can be produced by the barrier electrode (G4) being such that an undesirable constant component of the particular charge remains under the distribution electrode ($\Phi3^*$) and the alternating component lies above the barrier, and that laterally to the row of elektrodes, between the distributing electrode ($\Phi3^*$) and the barrier electrode (G4), there are arranged an exhaust gate ($\Phi5$) and an exhaust diode (ID$^*$), and that two shift electrodes ($\Phi4$ and $\Phi1$) which follow the barrier electrode (G4) respectively possess a larger surface than all respectively following shift electrodes ($\Phi2$ and $\Phi3$).

2. A CCD input circuit as claimed in claim 1, characterised in that the two shift electrodes ($\Phi4$ and $\Phi1$) following the barrier electrode (G4) respectively possess a surface which is twice as large as all respectively following shift electrodes ($\Phi2$ and $\Phi3$).

3. A method of operation of a CCD input circuit as clamimed in claim 1 oder claim 2, characterised in that a distribution clock train is provided in addition to the regular shift clock pulse tranis applied to the shift electrodes ($\Phi1$, $\Phi2$, $\Phi3$, $\Phi4$), this additional train being applied to the distribution electrode ($\Phi3^*$) and an exhaust clock pulse tranin is applied to the exhaust gate ($\Phi5$), the leading edge of the distribution clock pulses coinciding in time with the leading edge of the shift clock pulses applied to the third shift electrodes ($\Phi3$) and that the trailing edge of the distribution clock pulses occurs at a time following the trailing edge of the shift clock pulses applied to the fourth shift electrode ($\Phi4$), the leading edge of the exhaust clock pulses occurring at a time before the trailing edge of the shift clock pulses applied to the fourth shift electrode ($\Phi4$), and the trailing edge of the exhaust clock pulses occurring at a time following the trailing edge of the distribution clock pulses.

## Revendications

1. Circuit d'entrée CCD selon le principe »Fill and Spill«, comportant une diode d'entrée, plusieurs électrodes d'entrée et plusieurs électrodes de décalage disposées derrière lesdites électrodes d'entrée, caractérisé par le fait que la surface de chacune des premières électrodes décalage ($\Phi1$) ou de chacune des secondes électrodes ($\Phi2$) est égale à la somme des surfaces d'une seconde électrode d'entrée (G2) et d'une troisième électrode d'entrée (G3), qu'entre la seconde électrode de décalage ($\Phi2$) et une quatrième électrode de décalage ($\Phi4$) sont disposées une électrode de répartition ($\Phi3^*$) et une électrode de barrière (G4) qui est à un potentiel fixe qui correspond à une demi-amplitude de cadence, que la surface de l'électrode de répartition ($\Phi3^*$) et le niveau de la barrière susceptible d'être établi par une électrode de barrière (G4) sont dimensionnés de telle façon qu'une composante continue indésirable de la charge considérée subsiste sous l'électrode de répartition ($\Phi3^*$) et que la composante alternative se situe au-dessus de la barrière, que l'on dispose latéralement à la rangée d'électrodes, entre l'électrode de répartition ($\Phi3^*$) et l'électrode de barrière (G4) une grille d'extraction ($\Phi5$) et une diode d'extraction (ID$^*$) et que les deux électrodes de décalage($\Phi$, $\Phi1$) qui suivent l'électrode de barrière ont respectivement une surface supérieure à celle des électrodes de décalage suivantes ($\Phi2$, $\Phi3$).

2. Circuit d'entrée CCD selon la revendication 1, caractérisé par le fait que chacune des deux électrodes de décalage ($\Phi4$, $\Phi1$) qui suivent l'élelctrode de barrière (G4), a une surface qui est égale au double de celle de chacune des électrodes de décalage suivante ($\Phi2$, $\Phi3$).

3. Procédé pour opérer un circuit d'entrée CCD selon la revendication 1 ou 2, caractérisé par le fait qu'en plus des cadences de décalage régulières qui sont à appliquer aux électrodes de décalage ($\Phi1$, $\Phi2$, $\Phi3$, $\Phi4$), une cadence de répartition est prévue et est appliquée à l'électrode de répartition ($\Phi3^*$) et une cadence de succion à la grille de succion ($\Phi5$), que le flanc de mise en circuit de la cadence de répartition coincide, dans le temps, avec le flanc de mise en service de la cadence de décalage appliquée à la troisième électrode de décalage et le flanc de mise en service de la cadence de répartition est situé, dans le temps, aprés le flanc de mise en service de la cadence de décalage appliquée à la quatrième électrode de décalage ($\Phi$4), et que le flanc de mise en circuit de la cadence de succion se situe, dans le temps, avant le flanc de débranchement de la cadence de décalage appliquée à la quatrième électrode de décalage ($\Phi$4) alors que le flanc de débranchement de la cadence de succion se situe, dans le temps, après le flanc de débranchement de la cadence de répartition.

# FIG 1

# FIG 2

FIG 3

# FIG 4

# FIG 5